# EUROPÄISCHE PATENTSCHRIFT

(11) **EP 3 084 776 B1**
(45) Veröffentlichungstag und Bekanntmachung des Hinweises auf die Patenterteilung: **20.06.2018**
(21) Anmeldenummer: 13815479.4
(22) Anmeldetag: 19.12.2013
(51) Int. Cl.: H01B 1/02, H01B 1/22, H01L 31/18, H01L 31/0224

(54) **TRANSPARENTE NANODRAHTELEKTRODE MIT FUNKTIONALER ORGANISCHER SCHICHT**
TRANSPARENT NANOWIRE ELECTRODE WITH FUNCTIONAL ORGANIC LAYER
ELECTRODE À NANOFILS TRANSPARENTE POURVU D'UNE COUCHE ORGANIQUE FONCTIONNELLE

(43) Veröffentlichungstag der Anmeldung: 26.10.2016
(73) Patentinhaber: Fraunhofer-Gesellschaft zur Förderung der angewandten Forschung e.V., 80686 München (DE); Technische Universität Dresden, 01069 Dresden (DE)
(72) Erfinder: MÜLLER-MESKAMP, Lars, 01097 Dresden (DE); SELZER, Franz, 01219 Dresden (DE); BORMANN, Jan Ludwig, 01097 Dresden (DE); WEIß, Nelli, 01324 Dresden (DE); SACHSE, Christoph, 01067 Dresden (DE); GAPONIK, Nikolai, 01217 Dresden (DE); EYCHMÜLLER, Alexander, 01187 Dresden (DE)
(74) Vertreter: Schenk, Markus
(86) Internationale Anmeldenummer: PCT/EP2013/077358
(87) Internationale Veröffentlichungsnummer: WO 2015/090395

(56) Entgegenhaltungen:
- US-A1- 2012 118 617
- US-A1- 2013 105 770
- JUNG-YONG LEE ET AL: "Solution-Processed Metal Nanowire Mesh Transparent Electrodes", NANO LETTERS, Bd. 8, Nr. 2, 12. Januar 2008 (2008-01-12) , Seiten 689-692, XP055134260, ISSN: 1530-6984, DOI: 10.1021/nl073296g

## Beschreibung

Die vorliegende Erfindung betrifft allgemein eine transparente Elektrode für optoelektronische Bauelemente. Im Speziellen betrifft die vorliegende Erfindung eine transparente Nanodrahtelektrode für optoelektronische Bauelemente.

Die Herstellung optoelektronischer Bauelemente auf flexiblen Substraten ist ein wichtiges Feld aktueller Forschung. Die Verwendung organischer Materialien stellt hierbei einen großen Schritt zur Realisierung dieser dar. Zur externen Kontaktierung werden Elektroden benötigt, wovon mindestens eine notwendigerweise transparent sein muss. Diese Elektroden sollen besonderen Anforderungen genügen: Es wird eine hohe Leitfähigkeit bei gleichzeitig hoher Transparenz im sichtbaren Wellenlängenbereich benötigt. Ebenso ist es erforderlich, dass diese Elektroden unter mechanischer Belastung (Biegen) gleichbleibende optische und elektrische Eigenschaften zeigen. Des Weiteren soll die Herstellung dieser Elektroden preiswert und auf große Maßstäbe skalierbar sein, zum Beispiel auf Rolle-zu-Rolle-Verfahren übertragbar sein, und Materialien verwenden, welche eine hinreichende Verfügbarkeit aufweisen. Bisherige flexible Elektroden schaffen es nicht, alle Anforderungen gleichzeitig zu erfüllen.

Das state-of-the-art Material hierfür ist Indiumzinnoxid (ITO), welche einen niedrigen Schichtwiderstand RS bei gleichzeitig hoher Transparenz T aufweist. Dieses Material ist jedoch brüchig, sodass es für die Anwendung auf flexiblen Substraten nur bedingt in Frage kommt. In [Kim2009] wird eine flexible ITO-Elektrode vorgestellt, welche jedoch eine geringe Leitfähigkeit (RS ∼ 42 Ohm/sq) aufweist, welche sich bei mechanischer Belastung weiter verringert.

Eine erfolgversprechende Alternative zu ITO als transparente Elektroden stellen Metallnanodrähte aus Kupfer (CuNW) oder Silber (AgNW) dar, welche als zufällig orientiertes Perkolationsnetzwerk auf Glas- oder Foliensubstrate aufgebracht werden [Peumans2008], [Alden2007]. Elektroden mit Drähten aus Silber werden auch als AgNW-Elektroden bezeichnet. Sie zeichnen sich durch hohe Leitfähigkeit und Transmission, einfache Prozessierung (z.B. Sprühbeschichtungsprozesse) und sehr gute Flexibilitätseigenschaften aus. Bei der Herstellung dieser Schichten ist jedoch ein Postprozessierungsschritt nötig, um die Kontaktwiderstände zwischen den Nanodrähten zu reduzieren und somit einen niedrigen Schichtwiderstand zu erhalten.

Aktuell wird beispielsweise eine thermische Nachbehandlung (etwa 90 Minuten bei 210°C oder längere Zeit bei niedrigeren Temperaturen) zur Reduktion des Schichtwiderstands durchgeführt [Sachse2013]. Besonders die Nachbehandlung (z.B. Einwirken von Wärme) der Elektroden stellt eine große Hürde dar, da diese die Prozessierung stark verkompliziert. Dieser Schritt macht zudem die Anwendung auf flexiblen Substraten schwieriger, da viele Polymerfolien bei diesen Temperaturen ihre Flexibilität verlieren oder zerstört werden.

HU et al. zeigen in [Hu2010] eine flexible Elektrode mit einem geringen Schichtwiderstand von 12 Ohm/sq, welche bei 120 °C prozessiert wurde, allerdings mit niedriger Transmission (ca. 60% bei 550nm Wellenlänge).

In [De2009] stellen DE et al. flexible AgNW-Elektroden mit guten optischen und elektrischen Eigenschaften vor (T=85% ohne Substrat, RS=13 Ohm/sq), jedoch ist die Herstellung kompliziert (Transferprozess der AgNWs) und schwer skalierbar.

Einen einfachen 2-Schritt Sprühprozess zeigen Choi et al. [Choi2013a]. Hier wird eine AgNW-Elektrode mittels Sprühbeschichtung hergestellt, welche anschließend - auch im Sprühbeschichtungsverfahren - mit PEDOT:PSS bei 60°C beschichtet wird. Die so entstandene Elektrode benötigt keine weitere Wärmezufuhr und zeigt einen niedrigen Schichtwiderstand von RS =10,74 Ohm/sq bei einer Transmission von T=84%. Diese guten Werte werden dadurch erreicht, dass die Nanodrähte beim Aufbringen des PEDOT:PSS an den Kontaktstellen deformiert werden, so dass sich die Kontaktfläche zwischen übereinanderliegenden Nanodrähten vergrößert. Weiterhin ist PEDOT:PSS selbst leitfähig, so dass sowohl die Nanodrähte als auch in geringem Maße das PEDOT:PSS zur Leitfähigkeit der Elektrode beitragen. Der große Nachteil in [Choi2013a] ist, dass PEDOT:PSS zur Deformierung der Nanodrähte als Überschicht verwendet werden muss. PEDOT:PSS ist zudem sauer und greift nach und nach die Nanodrähte an, so dass derartige Elektroden eine geringe Lebensdauer aufweisen. Ein weiterer Nachteil von PEDOT:PSS ist die unerwünschte parasitäre Absorption, welche diese Schicht mit sich bringt.

Aus [Pschenitzka2013] ist eine organische Leuchtdiode bekannt, welche folgende Merkmale aufweist: Ein Substrat; eine erste Elektrode, welche auf dem Substrat angeordnet ist; eine organische Schicht, welche auf der ersten Elektrode angeordnet ist; und eine Nanostrukturschicht, welche eine Mehrzahl von Nanostrukturen beinhaltet, welche über der organischen Schicht angeordnet sind, wobei die Nanostrukturschicht eine zweite Elektrode ist.

Weiterhin ist aus [Bories-Azeau2012] eine transparente leitende Folie bekannt, welche folgende Merkmale umfasst: (i) ein polymeres Substrat, das eine polymere Basisschicht und eine polymere Bindeschicht umfasst, wobei das polymere Material der Basisschicht eine Erweichungstemperatur TS-B aufweist und das polymere Material der Bindeschicht eine Erweichungstemperatur TS-HS aufweist, wobei TS-HS mindestens 5 °C unter TS-B liegt; und (ii) eine leitende Schicht, die eine Vielzahl von Nanodrähten umfasst,wobei die Nanodrähte durch die polymere Matrix der Bindeschicht so gebunden werden, dass die Nanodrähte mindestens teilweise in der polymeren Matrix der Bindeschicht dispergiert sind; und wobei das polymere Substrat ein biaxial orientiertes Polyestersubstrat ist. Aufgabe der vorliegenden Erfindung ist es, eine transparente Nanodrahtelektrode zu verbessern.

Die Aufgabe wird durch eine transparente Elektrode sowie ein Verfahren zur Herstellung einer transparenten Elektrode gemäß den unabhängigen Ansprüchen gelöst.

Die erfindungsgemäße transparente Elektrode umfasst
wenigstens eine Trägerschicht zur Stabilisierung der Elektrode;
wenigstens eine Metallnanodrähte enthaltende elektrisch leitende Schicht, welche dadurch hergestellt ist, indem eine Suspension aus einer Flüssigkeit und den mit einer Stabilisierungsschicht umgebenen Metallnanodrähten entlang der Trägerschicht ausgebreitet und durch Entfernen der Flüssigkeit getrocknet ist; und
wenigstens eine funktionale entlang der Trägerschicht ausgebildete organische Schicht, welche während des Trocknens der elektrisch leitenden Schicht durch eine Wechselwirkung mit den Metallnanodrähten und/oder mit den Stabilisierungsschichten der Metallnanodrähte eine Wechselwirkung zwischen den Metallnanodrähten und den Stabilisierungsschichten so verändert, dass zwischen den Metallnanodrähten eine stoffschlüssige Verbindung entsteht.

Die Trägerschicht, auch Substrat genannt, ist insbesondere dazu vorgesehen, die transparente Elektrode mechanisch zu stabilisieren. Sie kann insbesondere als erste Schicht der Schichten der transparenten Elektrode hergestellt werden und somit eine Basis für die Herstellung der weiteren Schichten bilden. Die Trägerschicht kann formstabil oder bevorzugt flexibel ausgebildet sein. Formstabile Trägerschichten können insbesondere aus Glas bestehen. Demgegenüber bestehen flexible Trägerschichten bevorzugt aus Polymeren. Die Trägerschicht kann wiederum mit funktionalen Schichten, wie beispielsweise Gasbarrieren und Planarisierungsschichten, beschichtet sein.

Metallnanodrähte sind dabei leitende Drähte, welche eine Erstreckung in Querrichtung im Nanometerbereich aufweisen. Die die Metallnanodrähte enthaltende elektrisch leitende Schicht wird dadurch hergestellt, dass eine Suspension aus einer Flüssigkeit und den mit einer Stabilisierungsschicht umgebenen Metallnanodrähten entlang der Trägerschicht ausgebreitet und durch Entfernen der Flüssigkeit verfestigt wird. Die Stabilisierungsschicht kann dabei aus nicht vollständig entfernbaren Liganden oder Stabilisatoren welche zur Herstellung der Metallnanodrähte erforderlich sind, bestehen. Beispielsweise kann die Stabilisierungsschicht Polyvinylpyrrolidon (PVP) umfassen. Indem nun die Metallnanodrähte mit einer geeigneten Flüssigkeit, beispielsweise Ethanol oder Isopropanol, zu einer Suspension vermengt sind, kann die elektrisch leitende Schicht in einfacher Weise dadurch geformt werden, dass die Suspension flächig entlang der Trägerschicht ausgebreitet wird, wobei sich eine gleichmäßige Verteilung der Metallnanodrähte in der Form eines zufällig orientierten oder eines gezielt orientierten Perkolationsnetzwerks in der elektrisch leitenden Schicht ergibt. Die Suspension der elektrisch leitenden Schicht kann nun getrocknet werden, indem die Flüssigkeit, beispielsweise durch Verdampfen und/oder Verdunsten, entfernt wird. Aufgrund der Flexibilität der Metallnanodrähte ist eine derartige elektrisch leitende Schicht sehr flexibel.

Die wenigstens eine entlang der Trägerschicht ausgebildete funktionale organische Schicht, besteht aus einem organischen Material, welches während des Verfestigens der elektrisch leitenden Schicht mit den Metallnanodrähten und/oder mit den Stabilisierungsschichten der Metallnanodrähte eine starke Wechselwirkung aufweist. Dabei kann es sich um Van-der-Waals-Wechselwirkungen und/oder um andere elektrostatische Wechselwirkungen und/oder um kapillare Kräfte handeln. Eine geeignete Auswahl des organischen Materials kann dabei eine Wechselwirkung zwischen den Metallnanodrähten und den Stabilisierungsschichten so verändern, dass die vormals fest in ihrer jeweiligen Stabilisierungsschicht eingeschlossenen Metallnanodrähte einander unmittelbar berühren. Hierdurch kann zwischen den Metallnanodrähten eine stoffschlüssige Verbindung entstehen, welche beispielsweise durch eine Oberflächendiffusion zwischen den Metallnanodrähten bewirkt werden kann.

Unter einer stoffschlüssigen Verbindung wird dabei eine solche Verbindung verstanden, bei der die Verbindungspartner wenigstens teilweise durch atomare oder molekulare Kräfte zusammengehalten werden. Sie sind gleichzeitig nicht lösbare Verbindungen, die sich nur durch Zerstörung der Verbindungsmittel trennen lassen. Der stoffschlüssigen Verbindung kann dabei eine kraftschlüssige Verbindung und/oder eine formschlüssige Verbindung überlagert sein.

Weiterhin hat sich gezeigt, dass durch die oben genannten Wechselwirkungen die Metallnanodrähte ihrer Form destabilisiert werden können, so dass sich die Metallnanodrähte krümmen und dadurch aneinander anschmiegen können. Dies wiederum kann die Fläche, an welcher die Metallnanodrähte miteinander formschlüssig verbunden sind, vergrößern.

Beide Effekte können durch eine durch die funktionale organische Schicht hervorgerufene verstärkte Interaktion zwischen der Trägerschicht und den Metallnanodrähten begleitet werden, wodurch die Metallnanodrähte während des Trocknungsprozesses stärker an die Oberfläche der Trägerschicht herangezogen werden. Dadurch liegen die Metallnanodrähte flacher auf der Oberfläche der Trägerschicht. Darüber hinaus werden die Kräfte auf die Knotenpunkte erhöht. Dies führt wiederum in Kombination mit der schwachen strukturellen Destabilisierung der Nanodrähte zu einer Verbesserung der Kontaktgeometrie und begünstigt die stoffschlüssige Verbindung der Metallnanodrähte im Kontaktpunkt.

Durch die stoffschlüssigen Verbindungen sowie durch die vergrößerten Kontaktpunkte zwischen unterschiedlichen Metallnanodrähten weist die elektrisch leitende Schicht einen geringen Schichtwiderstand auf. Da die Dichte der Metallnanodrähte hierzu nicht erhöht werden muss, wird die Transparenz der elektrisch leitenden Schicht nicht eingeschränkt. Darüber hinaus kommen die stoffschlüssigen Verbindungen der Lebensdauer der Nanodrahtelektrode zugute, insbesondere dann, wenn eine flexible Trägerschicht verwendet wird. Hohe Prozesstemperaturen, wie beispielsweise in [Sachse2013] beschrieben, sind zur Herstellung der stoffschlüssigen Verbindungen nicht erforderlich.

Da die Metallnanodrähte sehr dünn sind, bleibt die Flexibilität der elektrisch leitenden Schicht weit gehend erhalten, auch wenn die Metallnanodrähte stoffschlüssig untereinander verbunden sind.

Die Erfindung vereinfacht die Herstellung von transparenten, hochleitfähigen, langlebigen und flexiblen Nanodrahtelektroden erheblich. Die Reduzierung der maximalen Prozesstemperatur und/oder der Dauer der Wärmeeinwirkung erlaubt die Verwendung von kostengünstigen transparenten Trägerschichten aus weniger temperaturbeständigen Materialien, wie beispielsweise Polyethylenterephthalat (PET), Polyethylennaphthalat (PEN) und/oder Polycarbonate (PC), und reduziert weiterhin die Kosten für die Herstellung der Nanodrahtelektrode.

Ein weiterer Vorteil ist, dass die Suspension in ihrer chemischen Zusammensetzung (z.B. Nanodrähte, Lösungsmittel, Stabilisatoren) variiert und mit weiteren Bestandteilen ergänzt werden kann, wobei keine Rücksicht auf Nachbehandlungsschritte zur Erhöhung der Leitfähigkeit genommen werden muss.

Die Erfindung stellt eine Möglichkeit dar, transparente und flexible Elektroden herzustellen, welche aktuelle Technologien in den oben genannten Kriterien übertreffen können.

Gemäß einer vorteilhaften Weiterbildung der Erfindung wirkt die organische Schicht bezüglich eines Materials der Stabilisierungsschicht als Lösungsmittel. Auf diese Weise kann die Wechselwirkung zwischen den Metallnanodrähten und den Stabilisierungsschichten so weit reduziert werden, dass die Stabilisierungsschichten soweit geschwächt werden, dass die Metallnanodrähte in unmittelbaren Kontakt miteinander gelangen und dann eine stoffschlüssige Verbindung eingehen können.

Nach einer vorteilhaften Weiterbildung der Erfindung besteht die organische Schicht überwiegend aus elektrisch nicht leitenden Komponenten. Es hat sich gezeigt, dass bei einer organischen Schicht aus überwiegend nicht leitenden Komponenten die Wechselwirkungen zwischen der funktionalen organischen Schicht und den Metallnanodrähten und/oder deren Stabilisierungsschichten stärker ausfallen , als in Fällen, in denen die organische Schicht aus überwiegend leitenden Komponenten besteht. Dies könnte darauf zurückzuführen sein, dass bei elektrisch nicht leitenden Komponenten ein elektrischer Ladungsausgleich nur beschränkt möglich ist. Die organische Schicht besteht dann aus überwiegend elektrisch nicht leitenden Komponenten, wenn der massenbezogene Anteil der elektrisch nicht leitenden Komponenten an der gesamten organischen Schicht wenigstens 50 % beträgt.

Nach einer vorteilhaften Weiterbildung der Erfindung beträgt der massenbezogene Anteil der nicht leitenden Komponenten an der organischen Schicht wenigstens 80%, bevorzugt wenigstens 90%, besonders bevorzugt wenigstens 95%. Bei den angegebenen Mindestwerten für den massenbezogenen Anteil der nicht leitenden Komponenten an der organischen Schicht kann ein besonders geringer Schichtwiderstand der transparenten Elektrode erreicht werden.

Gemäß einer vorteilhaften Weiterbildung der Erfindung beträgt die elektrische Leitfähigkeit der organischen Schicht höchstens 0,5 S/cm, bevorzugt höchstens 0,1 S/cm, besonders bevorzugt höchstens 0,05 S/cm. Bei den angegebenen Höchstwerten für die elektrische Leitfähigkeit der organischen Schicht ergeben sich hinreichend starke elektrostatische Wechselwirkungen zwischen der funktionalen organischen Schicht und den Metallnanodrähten und/oder den Stabilisierungsschichten der Metallnanodrähte um die Stabilisierungsschichten soweit zu schwächen, dass die Metallnanodrähte eine stoffschlüssige Verbindung eingehen können.

Nach einer vorteilhaften Weiterbildung der Erfindung weist die organische Schicht einen pH-Wert von mindestens 3, bevorzugt mindestens 3,5, besonders bevorzugt mindestens 4, auf. Bei den angegebenen Mindest-pH-Werten ist sichergestellt, dass die organische Schicht nicht derart sauer ist, dass die Komponenten der transparenten Elektrode, insbesondere die Trägerschicht und die Metallnanodrähte, auf Dauer chemisch zersetzt werden.

Gemäß einer zweckmäßigen Weiterbildung der Erfindung ist die Trägerschicht eine flexible Folie. Unter einer flexiblen Folie wird dabei ein flächiges Element verstanden, welches eine sehr geringe Höhe aufweist und ohne wesentliche Kräfte biegbar ist. Die Verwendung einer flexiblen Folie als Trägerschicht erleichtert die großflächige Herstellung transparenter Elektroden insbesondere unter Verwendung eines Rolle-zu-Rolle-Verfahrens. Geeignete Materialien für derartige flexible Folien sind beispielsweise Polyethylenterephthalat (PET), Polyethylennaphthalat (PEN) und/oder Polycarbonate (PC). Es sind jedoch auch andere Polymere oder sogar Metalle möglich.

Nach einer zweckmäßigen Weiterbildung der Erfindung umfassen die Metallnanodrähte Silbernanodrähte, Kupfernanodrähte, Metallnanodrähte aus Legierungen aus verschiedenen Metallen und/oder Core-Shell-Metallnanodrähte. Silbernanodrähte weisen ebenso wie Kupfernanodrähte einen geringen spezifischen Widerstand auf und sind einfach und kostengünstig herstellbar. Denkbar sind auch Metallnanodrähte, welche aus Legierungen aus verschiedenen Metallen bestehen. Ebenso möglich sind sogenannte Core-Shell-Metallnanodrähte, welche in ihrem Kern ein anderes Metall als an ihrer Hülle aufweisen. Dabei ist es jedoch bevorzugt, wenn sämtliche Metallnanodrähte einen gleichartigen Materialaufbau aufweisen, da stoffschlüssigen Verbindungen zwischen unterschiedlichen Materialien nur schwer erreichbar sind. Grundsätzlich ist jedoch die Verwendung von verschiedenen Materialien möglich, da dann die aus einem ersten Materialaufbau bestehenden Nanodrähte ebenso wie die aus einem zweiten Materialaufbau bestehenden Nanodrähte untereinander stoffschlüssigen Verbindungen ausbilden können .

Gemäß einer bevorzugten Weiterbildung der Erfindung ist die organische Schicht zwischen der Trägerschicht und der elektrisch leitenden Schicht ausgebildet. Dies ermöglicht ein Herstellungsverfahren, bei dem zuerst die Trägerschicht bereitgestellt wird, dann die organische Schicht unmittelbar oder mittelbar auf der Trägerschicht ausgebildet wird und danach die elektrisch leitende Schicht unmittelbar auf der funktionalen organischen Schicht ausgebildet wird. Dabei wird die organische Schicht bevorzugt unmittelbar auf der Trägerschicht ausgebildet. Es ist jedoch auch denkbar, zwischen der Trägerschicht und der organischen Schicht weitere Schichten, beispielsweise eine Haftvermittlerschicht zur Erhöhung der Haftung der organischen Schicht an der Trägerschicht, vorzusehen. Zwischen der organischen Schicht und der elektrisch leitenden Schicht ist in der Regel keine weitere Schicht vorgesehen, umso eine starke Wechselwirkung zwischen der organischen Schicht und den Metallnanodrähten bzw. ihren Stabilisierungsschichten zu erreichen. Grundsätzlich sind auch Ausführungsbeispiele denkbar, welche mehrere organische Schichten und oder mehrere elektrisch leitende Schicht aufweisen. Dabei sind insbesondere alternierende Schichtabfolge aus organischer Schichten leitfähiger Schicht möglich. Beispielsweise könnte auf die Trägerschicht eine erste organische Schicht, dann eine erste leitende Schicht, dann eine zweite organische Schicht und dann eine zweite leitende Schicht aufgebracht sein.

Ein Vorteil der organischen Schicht unter den Nanodrähten ist, dass sie am Ende des Prozesses noch offen liegen. Hier ist eine Weiterverarbeitung in jeglicher denkbarer Art und Weise vorstellbar. Auch die optischen Eigenschaften, zum Beispiel die gezielte Veränderung der Streueigenschaften dieser Schicht, lassen sich dann noch unabhängig optimieren.

Nach einer bevorzugten Weiterbildung der Erfindung ist die elektrisch leitende Schicht auf einer der organischen Schicht abgewandten Seite mit einer transparenten Abdeckschicht versehen. Dies reduziert Unebenheiten, welche durch die Nanodrähte entstehen und verringert somit Probleme in der Weiterverarbeitung der Elektrode.

Gemäß einer bevorzugten Weiterbildung der Erfindung ist die organische Schicht auf der der Trägerschicht abgewandten Seite der elektrischen Schicht ausgebildet. In diesem Fall wird ein Herstellungsverfahren möglich, bei dem zuerst die Trägerschicht bereitgestellt wird, dann die elektrisch leitende Schicht unmittelbar oder mittelbar auf die Trägerschicht aufgebracht wird und danach die organische Schicht auf der elektrisch leitenden Schicht ausgebildet wird. In derartigen Ausführungsbeispielen ist es bevorzugt, wenn die elektrisch leitende Schicht unmittelbar auf die Trägerschicht aufgebracht wird. Es ist jedoch auch möglich, zwischen der Trägerschicht und der elektrisch leitenden Schicht weitere Schichten vorzusehen. So kann beispielsweise eine Haftvermittlerschicht zur Erhöhung der Haftung der leitfähigen Schicht, eine Streuschicht zum Streuen von Licht und/oder eine Gasbarriere an der Trägerschicht vorgesehen sein.

Nach einer bevorzugten Weiterbildung der Erfindung ist die organische Schicht mittels eines Rotations-, Sprüh- und/oder Tauchbeschichtungsverfahrens hergestellt, indem ein in einem Lösungsmittel gelöstes organisches Material ausgebreitet und durch Entfernen des Lösungsmittels verfestigt ist. Bei einem Rotationsbeschichtungsverfahren wird allgemein flüssiges Material auf ein rotierendes Substrat aufgebracht, so dass das flüssige Material aufgrund der Fliehkraft eine sehr dünne Schicht aus bildet. Bei einem Sprühbeschichtungsverfahren wird allgemein ein flüssiges Material auf ein Substrat auf gesprüht. Weiterhin wird bei einem Tauchbeschichtungsverfahren das Substrat in ein flüssiges Material eingetaucht und wieder herausgenommen. Alternativ können auch Druckverfahren, wie beispielsweise Gravurstreichen, Rollrakel-Streichverfahren oder Schlitzdüsenbeschichtungsverfahren zur Herstellung der organischen Schicht verwendet werden. Im vorliegenden Fall kann das in einem Lösungsmittel gelöste organische Material je nach Ausführungsbeispiel auf die als Substrat dienende Trägerschicht oder die als Substrat dienende leitende Schicht aufgebracht werden, um die funktionale organische Schicht herzustellen.

Nach einer vorteilhaften Weiterbildung der Erfindung umfasst das Entfernen des Lösungsmittels einen Heizschritt mit einer Maximaltemperatur, welche höchstens 150°C, bevorzugt höchstens 120°C, besonders bevorzugt höchstens 100°C, beträgt. Bei den genannten Maximaltemperaturen können gängige Lösungsmittel in hinnehmbarer Zeit durch verdunsten und/oder verdampfen entfernt werden, so dass die organische Schicht getrocknet wird. Gleichzeitig wird bei den genannten Maximaltemperaturen eine thermische Überbelastung der Komponenten der transparenten Elektrode, insbesondere der Trägerschicht, vermieden. Die Verwendung von temperaturempfindlichen Trägerschichten wird in vielen Fällen so erst möglich. Zudem kann so der Energieaufwand bei der Herstellung der transparenten Elektrode verringert werden.

Gemäß einer vorteilhaften Weiterbildung der Erfindung ist die Suspension mittels eines Rotations-, Sprüh- , Druck und/oder Tauchbeschichtungsverfahrens ausgebreitet. Je nach Ausführungsbeispiel kann die Suspension auf die als Substrat dienende Trägerschicht oder die als Substrat dienende funktionale organische Schicht aufgebracht werden, um die elektrisch leitende Schicht herzustellen.

Nach einer vorteilhaften Weiterbildung der Erfindung ist die Suspension während des Ausbreitens beheizt, wobei eine maximale Temperatur der Suspension höchstes 100°C, bevorzugt höchstens 80°C, besonders bevorzugt höchstens 70°C beträgt. Bei den angegebenen maximalen Temperaturen wird eine gleichmäßige Verteilung der Metallnanodrähte gewährleistet. Zudem fördern die angegebenen maximalen Temperaturen eine rasche Verfestigung der elektrisch leitenden Schicht, ohne dass die Komponenten der transparenten Elektrode thermisch zu stark belastet werden.

Gemäß einer vorteilhaften Weiterbildung der Erfindung umfasst das organische Material ein wasserlösliches Polymer und/oder ein alkohollösliches Polymer, insbesondere ein ungeladenes Polymer, ein anionisches Polymer und/oder ein kationisches Polymer. Wasserlösliche und alkohollösliche Polymere bilden starke elektrische Wechselwirkungen mit den Metallnanodrähten und/oder mit den Stabilisierungsschichten der Metallnanodrähte aus. Dabei sind sie leicht verarbeitbar und umweltfreundlich. Verwendet werden können sowohl synthetische als auch natürlich vorkommende Polymere. Hierbei ist es möglich, ungeladene Polymere oder geladene Polymere, nämlich kationische Polyelektrolyte oder anionische Polyelektrolyte, zu verwenden.

Geeignete ungeladene Polymere sind zum Beispiel: Polyvinylalkohol, Copolymere von Vinylalkohol, Polyvinylpyrrolidon, Polyacrylamide und Polyisocyanate.

Unter anderem sind folgende kationische Polyelektrolyte geeignet: Chitosan, modifizierte Dextrane, z.B. Diethylaminoethylmodifizierte Dextrane, Hydroxymethylcellulosetrimethylamin, Lysozym, Polylysin, Protaminsulfat, Hydroxyethylcellulosetrimethylamin und Proteine bei einem entsprechenden pH-Wert. Beispiele für synthetische Polykationen sind Polyallylamin, Polyallylaminhydrochlorid, Polyamine, Polyvinylbenzyltrimethylammoniumchlorid, Polybren, Polydiallyldimethylammoniumchlorid, Polyethylenimin, Polyimidazolin, Polyvinylamin, Polyvinylpyridin, Poly(acrylamid/methacryloxypropyltrimethylammoniumbromid), Poly(diallyldimethylammoniumchlorid/N-isopropylacrylamid), Poly(dimethylaminoethylacrylaUacrylamid), Polydimethylaminoethylmethacrylat, Polydimethylamino-epichlorhydrin, Polyethyleniminoepichlorhydrin, Polymethacryloxyethyltrimethylammoniumbromid, Hydroxypropylmethacryloxyethyldimethylammoniumchlorid, Poly(methyldiethylaminoethylmethacrylat/ acrylamid), Poly(methyl/guanidin), Polymethylvinylpyridiniumbromid, Poly(vinylpyrrolidon-dimethylaminoethylmethacrylat) und Polyvinylmethylpyridiniumbromid.

Beispiele für geeignete natürlich vorkommende Polyanionen sind Alginat, Carboxymethylamylose, Carboxymethylcellulose, Carboxy-5 methyldextran, Carageenan, Cellulosesulfat, Chondroitinsulfat, Chitosansulfat, Dextransulfat, Gummi Arabicum, Gummi Guar, Gummi Gellan, Heparin, Hyaluronsäure, Pektin, Xanthan und Proteine bei einem entsprechenden pH-Wert. Beispiele für synthetische Polyanionen sind Polyacrylate (Salze der Polyacrylsäure), Anionen von Polyaminosäuren und deren Copolymeren, Polymaleinat, Polymethacrylat; Polystyrolsulfat, Polystyrolsulfonat, Polyvinylphosphat, Polyvinylphosphonat, Polyvinylsulfat, Polyacrylamidmethylpropansulfonat, Polylactat, Poly(butadien/maleinat), Poly(ethylen/maleinat), Poly(ethacrylaUacrylat) und Poly(glycerinmethacrylat).

Nach einer vorteilhaften Weiterbildung der Erfindung umfasst das organische Material ein Tensid, insbesondere ein nichtionisches Tensid, ein anionisches Tensid, ein kationisches Tensid und/oder ein amphoteres Tensid. Tenside bilden ebenfalls starke elektrische Wechselwirkungen mit den Metallnanodrähten und/oder mit den Stabilisierungsschichten der Metallnanodrähte aus. Dabei sind sie ebenfalls leicht verarbeitbar und umweltfreundlich. Verwendet werden können sowohl synthetische als auch natürlich vorkommende Tenside.

Geeignete nichtionische Tenside sind beispielsweise: Fettalkoholethoxlate, Fettalkoholethoxylate, Alkylpolyglucoside (unter anderen: Polyethylenglykol, Polyethylenglykolmethylether).

Geeignete anionische Tenside sind beispielsweise: Alkylbenzolsulfonate (CnH2n+1-C6H4-SO3-Na+), Fettalkoholsulfate (H3C-(CH2)n-CH2-O-SO3-Na+ [n = 8-16]), Alkylcarboxylate (R-COO-Na+, mit R = gesättigter oder ungesättigter, linearer Alkylrest), Seifen (unter anderen: Natriumdodecylbenzolsulfonat, Natriumlaurylsulfat, Natriumoctanoat).

Kationische geeignete Tenside sind unter anderem: Cetylpyridiniumchlorid, Cetyltrimethylammoniumbromid, Tetrabutylammoniumbromid, Tetrakis(decyl)ammoniumbromide.

Amphotere geeignete Tenside sind beispielsweise: Betaine, Sultaine, Taurin.

Das Verfahren zur Herstellung einer transparente Elektrode umfasst die Schritte:
Bereitstellen wenigstens einer Trägerschicht zur Stabilisierung der Elektrode;
Herstellen wenigstens einer Metallnanodrähte enthaltenden elektrisch leitenden Schicht, indem eine Suspension aus einer Flüssigkeit und den mit einer Stabilisierungsschicht umgebenen Metallnanodrähten entlang der Trägerschicht ausgebreitet und durch Entfernen der Flüssigkeit getrocknet wird; und
Ausbilden wenigstens einer funktionalen organische Schicht entlang der Trägerschicht, welche während des Trocknens der elektrisch leitenden Schicht durch eine Wechselwirkung mit den Metallnanodrähten und/oder mit den Stabilisierungsschichten der Metallnanodrähte eine Wechselwirkung zwischen den Metallnanodrähten und den Stabilisierungsschichten so verändert, dass zwischen den Metallnanodrähten eine stoffschlüssige Verbindung entsteht.

Es ergeben sich die oben genannten Vorteile.

Die vorstehend erläuterten und/oder in den Unteransprüchen wiedergegebenen vorteilhaften Aus- und Weiterbildungen der Erfindung können dabei, außer z. B. in den Fällen eindeutiger Abhängigkeiten oder unvereinbarer Alternativen, einzeln oder aber auch in beliebiger Kombination miteinander zur Anwendung kommen.

Die Erfindung und ihre vorteilhaften Aus- und Weiterbildungen sowie deren Vorteile werden nachfolgend anhand von Zeichnungen näher erläutert.

Es zeigen, jeweils in einer schematischen Prinzipskizze:
- Fig. 1: ein erstes Ausführungsbeispiel einer erfindungsgemäßen flexiblen und transparenten Elektrode in einer schematischen Seitenansicht;
- Fig. 2: ein zweites Ausführungsbeispiel einer erfindungsgemäßen flexiblen und transparenten Elektrode in einer schematischen Seitenansicht;
- Fig. 3: ein drittes Ausführungsbeispiel einer erfindungsgemäßen flexiblen und transparenten Elektrode in einer schematischen Seitenansicht;
- Fig. 4: ein Ausführungsbeispiel eines erfindungsgemäßen Verfahrens in einer schematischen Ansicht;
- Fig. 5: eine rasterelektronenmikroskopische Aufnahme einer transparenten Elektrode, welche gemäß dem Stand der Technik ohne funktionale organische Schicht ausgebildet ist;
- Fig. 6: eine rasterelektronenmikroskopische Aufnahme einer transparenten Erfindungsgemäßen Elektrode, welche zwischen der Trägerschicht und der elektrisch leitenden Schicht eine funktionale organische Schicht aufweist;
- Fig. 7: eine rasterelektronenmikroskopische Aufnahme einer transparenten erfindungsgemäßen Elektrode, bei welcher die elektrisch leitende Schicht zwischen der Trägerschicht und der funktionalen organische Schicht angeordnet ist;
- Fig. 8: ein Diagramm, welches den Schichtwiderstand und den Transmissionsgrad einer Elektrode in Abhängigkeit von dem Material der funktionalen organischen Schicht darstellt; und
- Fig. 9: ein Diagramm, welches den Schichtwiderstand und den Transmissionsgrad einer Elektrode in Abhängigkeit von dem Anteil nicht leitenden Komponente an den Material der funktionalen organischen Schicht darstellt.

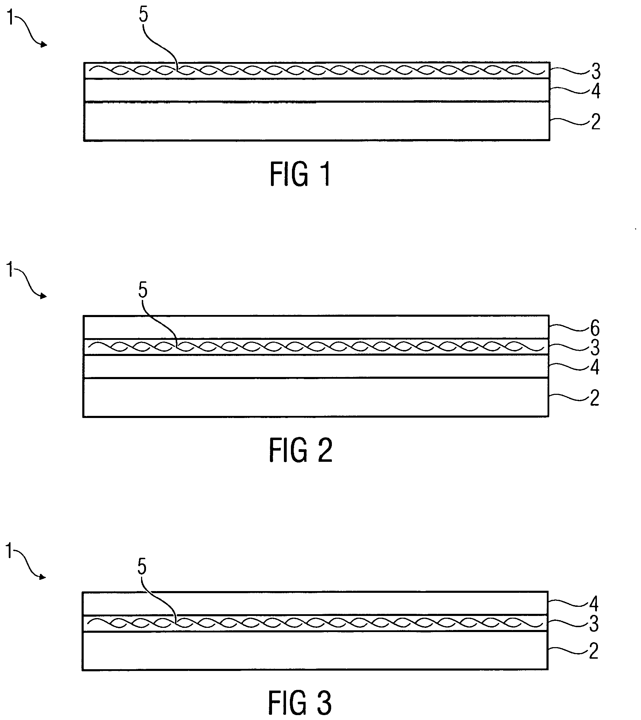

Figur 1 zeigt ein erstes Ausführungsbeispiel einer erfindungsgemäßen flexiblen und transparenten Elektrode 1 in einer schematischen Seitenansicht. Die transparente Elektrode 1 umfasst wenigstens eine Trägerschicht 2 zur Stabilisierung der Elektrode 1, wenigstens eine Metallnanodrähte 5 enthaltende elektrisch leitende Schicht 3, welche dadurch hergestellt ist, dass eine Suspension aus einer Flüssigkeit und den mit einer Stabilisierungsschicht umgebenen Metallnanodrähten 5 entlang der Trägerschicht 2 ausgebreitet und durch Entfernen der Flüssigkeit verfestigt ist, und wenigstens eine funktionale entlang der Trägerschicht 2 ausgebildete organische Schicht 4, welche während des Verfestigens der elektrisch leitenden Schicht 3 durch eine elektrische Wechselwirkung mit den Metallnanodrähten 5 und/oder mit den Stabilisierungsschichten der Metallnanodrähte 5 eine Wechselwirkung zwischen den Metallnanodrähten 5 und den Stabilisierungsschichten so verändert, dass zwischen den Metallnanodrähten 5 eine stoffschlüssige Verbindung entsteht.

Gemäß einer bevorzugten Weiterbildung der Erfindung ist die organische Schicht 4 zwischen der Trägerschicht 2 und der elektrisch leitenden Schicht ausgebildet 3. Dies ermöglicht ein Herstellungsverfahren, bei dem zuerst die Trägerschicht 2 bereitgestellt wird, dann die organische Schicht 4 unmittelbar oder mittelbar auf der Trägerschicht 2 ausgebildet wird und danach die elektrisch leitende Schicht 3 unmittelbar auf der funktionalen organischen Schicht 4 ausgebildet wird. Dabei wird die organische Schicht 4 bevorzugt unmittelbar auf der Trägerschicht 2 ausgebildet. Es ist jedoch auch denkbar, zwischen der Trägerschicht 2 und der organischen Schicht 4 weitere Schichten, beispielsweise eine Haftvermittlerschicht zur Erhöhung der Haftung der organischen Schicht 4 an der Trägerschicht 2, vorzusehen. Zwischen der organischen Schicht 4 und der elektrisch leitenden Schicht 3 ist in der Regel keine weitere Schicht vorgesehen, um so eine starke Wechselwirkung zwischen der organischen Schicht 4 und den Metallnanodrähten 5 bzw. ihren Stabilisierungsschichten zu erreichen.

Ein Vorteil der organischen Schicht 4 unter den Nanodrähten 5 ist, dass sie am Ende des Prozesses noch offen liegen. Hier ist eine Weiterverarbeitung in jeglicher denkbarer Art und Weise vorstellbar. Auch die optischen Eigenschaften, zum Beispiel die gezielte Veränderung der Streueigenschaften dieser Schicht 3, lassen sich dann noch unabhängig optimieren.

Figur 2 zeigt ein zweites Ausführungsbeispiel einer erfindungsgemäßen flexiblen und transparenten Elektrode in einer schematischen Seitenansicht. Nach einer hier gezeigt bevorzugten Weiterbildung der Erfindung ist die elektrisch leitende Schicht 3 auf einer der organischen Schicht 4 abgewandten Seite mit einer transparenten Abdeckschicht 6 versehen. Dies reduziert Unebenheiten, welche durch die Nanodrähte 5 entstehen und verringert somit Probleme in der Weiterverarbeitung der Elektrode.

Figur 3 zeigt ein drittes Ausführungsbeispiel einer erfindungsgemäßen flexiblen und transparenten Elektrode in einer schematischen Seitenansicht. Gemäß einer hier gezeigten bevorzugten Weiterbildung der Erfindung ist die organische Schicht 4 auf der der Trägerschicht 2 abgewandten Seite der elektrisch leitenden Schicht 3 ausgebildet. In diesem Fall wird ein Herstellungsverfahren möglich, bei dem zuerst die Trägerschicht 2 bereitgestellt wird, dann die elektrisch leitende Schicht 3 unmittelbar oder mittelbar auf die Trägerschicht 2 aufgebracht wird und danach die organische Schicht 4 auf der elektrisch leitenden Schicht 3 ausgebildet wird. In derartigen Ausführungsbeispielen ist es bevorzugt, wenn die elektrisch leitende Schicht 3 unmittelbar auf die Trägerschicht 2 aufgebracht wird. Es ist jedoch auch möglich, zwischen der Trägerschicht 2 und der elektrisch leitenden Schicht 3 weitere Schichten vorzusehen. So kann beispielsweise eine Haftvermittlerschicht zur Erhöhung der Haftung der leitfähigen Schicht 2 an der Trägerschicht 2 vorgesehen sein.

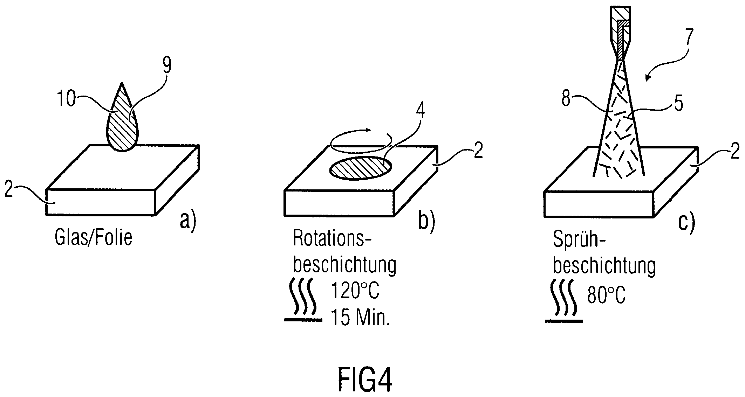

Figur 4 zeigt ein Ausführungsbeispiel eines erfindungsgemäßen Verfahrens in einer schematischen Ansicht. Das Verfahren zur Herstellung einer transparente Elektrode 1 umfasst die Schritte:
- Bereitstellen wenigstens einer Trägerschicht 2 zur Stabilisierung der Elektrode 1;
- Ausbilden wenigstens einer funktionalen organischen Schicht 4 entlang der Trägerschicht 2, welche während des Verfestigens der elektrisch leitenden Schicht 3 durch eine elektrische Wechselwirkung mit den Metallnanodrähten 5 und/oder mit den Stabilisierungsschichten der Metallnanodrähte 5 eine Wechselwirkung zwischen den Metallnanodrähten 5 und den Stabilisierungsschichten so verändert, dass zwischen den Metallnanodrähten 5 eine stoffschlüssige Verbindung entsteht; und
- Herstellen wenigstens einer Metallnanodrähte 5 enthaltenden elektrisch leitenden Schicht 3, indem eine Suspension 7 aus einer Flüssigkeit 8 und den mit einer Stabilisierungsschicht umgebenen Metallnanodrähten 5 entlang der Trägerschicht 2 ausgebreitet und durch Entfernen der Flüssigkeit 8 verfestigt wird.

Die Herstellung der funktionalisierten Silbernanodrahtelektroden 1 kann in einem Ausführungsbeispiel folgendermaßen durchgeführt werden: Ein im ersten Schritt bereitgestelltes Substrat 2 wird mit der Organik 4 im zweiten Schritt rotationsbeschichtet und anschließend bei 120°C für 15 Minuten ausgeheizt. Anschließend werden die Nanodrähte 5 im dritten Schritt bei einer Substrattemperatur von 80°C mittels eines Sprühbeschichtungsverfahren aufgebracht.

Die Trägerschicht 2 ist insbesondere dazu vorgesehen, die transparente Elektrode 1 mechanisch zu stabilisieren. Sie kann insbesondere als erste Schicht der Schichten 2, 3, 4, 5 der transparenten Elektrode 1 hergestellt werden und somit eine Basis für die Herstellung der weiteren Schichten 3, 4, 5 bilden. Die Trägerschicht 2 kann formstabil oder bevorzugt flexibel ausgebildet sein. Formstabile Trägerschichten können insbesondere aus Glas bestehen. Demgegenüber bestehen flexible Trägerschichten 2 bevorzugt aus Polymeren.

Metallnanodrähte 5 sind dabei leitende Drähte, welche eine Erstreckung in Querrichtung im Nanometerbereich aufweisen. Die die Metallnanodrähte 5 enthaltende elektrisch leitende Schicht 3 wird im dritten Schritt dadurch hergestellt, dass eine Suspension 7 aus einer Flüssigkeit 8 und den mit einer Stabilisierungsschicht umgebenen Metallnanodrähten 5 entlang der Trägerschicht 2 ausgebreitet und durch Entfernen der Flüssigkeit 8 verfestigt wird. Die Stabilisierungsschicht kann dabei aus nicht vollständig entfernbaren Liganden, welche zur Herstellung der Metallnanodrähte 5 erforderlich sind, bestehen. Beispielsweise kann die Stabilisierungsschicht Polyvinylpyrrolidon (PVP) umfassen. Indem nun die Metallnanodrähte 5 mit einer geeigneten Flüssigkeit 8, beispielsweise Ethanol oder Isopropanol, zu einer Suspension 7 vermengt sind, kann die elektrisch leitende Schicht 3 in einfacher Weise dadurch geformt werden, dass die Suspension 7 flächig entlang der Trägerschicht 2 ausgebreitet wird, wobei sich eine gleichmäßige Verteilung der Metallnanodrähte 5 in der Form eines zufällig orientierten Perkolationsnetzwerks in der elektrisch leitenden Schicht 3 ergibt. Die Suspension 7 der elektrisch leitenden Schicht 3 kann nun verfestigt werden, indem die Flüssigkeit 8, beispielsweise durch Verdampfen und/oder Verdunsten, entfernt wird. Aufgrund der Flexibilität der Metallnanodrähte 5 ist eine derartige elektrisch leitende Schicht 3 sehr flexibel.

Die wenigstens eine im zweiten Schritt entlang der Trägerschicht ausgebildete funktionale organische Schicht 4, besteht aus einem organischen Material, welches während des Verfestigens der elektrisch leitenden Schicht 3 mit den Metallnanodrähten 5 5 und/oder mit den Stabilisierungsschichten der Metallnanodrähte eine elektrische Wechselwirkung aufweist. Dabei kann es sich um Van-der-Waals-Wechselwirkungen und/oder um elektrostatische Wechselwirkungen handeln. Eine geeignete Auswahl des organischen Materials kann dabei eine Wechselwirkung zwischen den Metallnanodrähten 5 und den Stabilisierungsschichten so verändern, dass die vormals fest in ihrer jeweiligen Stabilisierungsschicht eingeschlossenen Metallnanodrähte 5 einander unmittelbar berühren. Hierdurch kann zwischen den Metallnanodrähten 5 eine stoffschlüssige Verbindung entstehen, welche beispielsweise durch eine Oberflächendiffusion zwischen den Metallnanodrähten 5 bewirkt werden kann.

Durch die stoffschlüssigen Verbindungen zwischen unterschiedlichen Metallnanodrähten 5 weist die elektrisch leitende Schicht 3 einen geringen Schichtwiderstand auf. Da die Bedeckungsdichte der Metallnanodrähte 5 hierzu nicht erhöht werden muss, wird die Transparenz der elektrisch leitenden Schicht 3 nicht eingeschränkt. Darüber hinaus kommen die stoffschlüssigen Verbindungen der Lebensdauer der Nanodrahtelektrode 1 zugute, insbesondere dann, wenn eine flexible Trägerschicht 2 verwendet wird. Hohe Prozesstemperaturen, wie beispielsweise in [Sachse2013] beschrieben, sind zur Herstellung der stoffschlüssigen Verbindungen nicht erforderlich.

Da die Metallnanodrähte 5 sehr dünn sind, bleibt die Flexibilität der elektrisch leitenden Schicht weit gehend erhalten, auch wenn die Metallnanodrähte 5 stoffschlüssig untereinander verbunden sind.

Die Erfindung vereinfacht die Herstellung von transparenten, hochleitfähigen, langlebigen und flexiblen Nanodrahtelektroden 1 erheblich. Die Reduzierung der maximalen Prozesstemperatur und/oder der Dauer der Wärmeeinwirkung erlaubt die Verwendung von kostengünstigen transparenten Trägerschichten 2 aus weniger temperaturbeständigen Materialien, wie beispielsweise Polyethylenterephthalat (PET), Polyethylennaphthalat (PEN) und/oder Polycarbonate (PC), und reduziert weiterhin die Kosten für die Herstellung der Nanodrahtelektrode 1.

Ein weiterer Vorteil ist, dass die Suspension 7 in ihrer chemischen Zusammensetzung (z.B. Nanodrähte 5, Lösungsmittel 8, Stabilisatoren) variiert und mit weiteren Bestandteilen ergänzt werden kann, wobei keine Rücksicht auf Nachbehandlungsschritte zur Erhöhung der Leitfähigkeit genommen werden muss.

Die Erfindung stellt eine Möglichkeit dar, transparente und flexible Elektroden 1 herzustellen, welche aktuelle Technologien in den oben genannten Kriterien übertreffen können.

Nach einer bevorzugten Weiterbildung der Erfindung ist die organische Schicht 4 mittels eines Rotations-, Sprüh-, Druck und/oder Tauchbeschichtungsverfahrens hergestellt, indem ein in einem Lösungsmittel 9 gelöstes organisches Material 10 ausgebreitet und durch Entfernen des Lösungsmittels 9 verfestigt ist. Bei einem Rotationsbeschichtungsverfahren wird, wie in Figur 4 angedeutet, allgemein flüssiges Material auf ein rotierendes Substrat aufgebracht, so dass das flüssige Material aufgrund der Fliehkraft eine sehr dünne Schicht aus bildet. Bei einem Sprühbeschichtungsverfahren wird allgemein ein flüssiges Material auf ein Substrat auf gesprüht. Weiterhin wird bei einem Tauchbeschichtungsverfahren das Substrat in ein flüssiges Material eingetaucht und wieder herausgenommen. Im vorliegenden Fall kann das in einem Lösungsmittel 9 gelöste organische Material 10 je nach Ausführungsbeispiel auf die als Substrat dienende Trägerschicht 2 oder die als Substrat dienende leitende Schicht aufgebracht werden, um die funktionale organische Schicht 4 herzustellen.

Nach einer vorteilhaften Weiterbildung der Erfindung umfasst das Entfernen des Lösungsmittels 9 einen Heizschritt mit einer Maximaltemperatur, welche höchstens 150°C, bevorzugt höchstens 120°C, besonders bevorzugt höchstens 100°C, beträgt. Bei den genannten Maximaltemperaturen können gängige Lösungsmittel 9 in hinnehmbarer Zeit durch verdunsten und/oder verdampfen entfernt werden, so dass die organische Schicht 4 verfestigt wird. Gleichzeitig wird bei den genannten Maximaltemperaturen eine thermische Überbelastung der Komponenten der transparenten Elektrode 1 vermieden. Zudem kann so der Energieaufwand bei der Herstellung der transparenten Elektrode 1 verringert werden.

Gemäß einer vorteilhaften Weiterbildung der Erfindung ist die Suspension mittels eines Rotations-, Sprüh- und/oder Tauchbeschichtungsverfahrens ausgebreitet. Je nach Ausführungsbeispiel kann die Suspension auf die als Substrat dienende Trägerschicht oder die als Substrat dienende funktionale organische Schicht aufgebracht werden, um die elektrisch leitende Schicht herzustellen.

Nach einer vorteilhaften Weiterbildung der Erfindung ist die Suspension während des Ausbreitens beheizt, wobei eine maximale Temperatur der Suspension höchstes 100°C, bevorzugt höchstens 80°C, besonders bevorzugt höchstens 70°C beträgt. Bei den angegebenen maximalen Temperaturen wird eine gleichmäßige Verteilung der Metallnanodrähte gewährleistet. Zudem fördern die angegebenen maximalen Temperaturen eine rasche Verfestigung der elektrisch leitenden Schicht 3, ohne dass die Komponenten der transparenten Elektrode 1 thermisch zu stark belastet werden.

Gemäß einer vorteilhaften Weiterbildung der Erfindung wirkt die organische Schicht 4 bezüglich eines Materials der Stabilisierungsschicht als Lösungsmittel. Auf diese Weise kann die Wechselwirkung zwischen den Metallnanodrähten 5 und den Stabilisierungsschichten so weit reduziert werden, dass die Stabilisierungsschichten soweit geschwächt werden, dass die Metallnanodrähte 5 in unmittelbaren Kontakt miteinander gelangen und dann eine stoffschlüssige Verbindung eingehen können.

Nach einer vorteilhaften Weiterbildung der Erfindung weist die organische Schicht 4 einen pH-Wert von mindestens 3, bevorzugt mindestens 3,5, besonders bevorzugt mindestens 4, auf. Bei den angegebenen Mindest-pH-Werten ist sichergestellt, dass die organische Schicht 4 nicht derart sauer ist, dass die Komponenten der transparenten Elektrode 1, insbesondere die Trägerschicht 2 und die Metallnanodrähte 5, auf Dauer chemisch zersetzt werden.

Gemäß einer zweckmäßigen Weiterbildung der Erfindung ist die Trägerschicht 2 eine flexible Folie. Unter einer flexiblen Folie wird dabei ein flächiges Element verstanden, welches eine sehr geringe Höhe aufweist und ohne wesentliche Kräfte biegbar ist. Die Verwendung einer flexiblen Folie als Trägerschicht 2 erleichtert die großflächige Herstellung transparenter Elektroden 1, insbesondere unter Verwendung eines Rolle-zu-Rolle-Verfahrens. Geeignete Materialien für derartige flexible Folien sind beispielsweise Polyethylenterephthalat (PET), Polyethylennaphthalat (PEN) und/oder Polycarbonate (PC). Es sind jedoch auch andere Polymere oder sogar Metalle möglich.

Nach einer zweckmäßigen Weiterbildung der Erfindung umfassen die Metallnanodrähte 5 Silbernanodrähte und/oder Kupfernanodrähte. Silbernanodrähte weisen ebenso wie Kupfernanodrähte einen geringen spezifischen Widerstand auf und sind einfach und kostengünstig herstellbar. Dabei ist es jedoch bevorzugt, wenn sämtliche Metallnanodrähte 5 aus einem einzigen Material bestehen, da stoffschlüssigen Verbindungen zwischen unterschiedlichen Materialien nur schwer erreichbar sind. Grundsätzlich ist jedoch die Verwendung von verschiedenen Materialien möglich, da dann die aus einem ersten Material bestehenden Nanodrähte 5 ebenso wie die aus einem zweiten Material bestehenden Nanodrähte 5 untereinander stoffschlüssigen Verbindungen ausbilden können.

Gemäß einer vorteilhaften Weiterbildung der Erfindung umfasst das organische Material 10 ein wasserlösliches Polymer und/oder ein alkohollösliches Polymer, insbesondere ein ungeladenes Polymer, ein anionisches Polymer und/oder ein kationisches Polymer. Wasserlösliche und alkohollösliche Polymere bilden starke elektrische Wechselwirkungen mit den Metallnanodrähten und/oder mit den Stabilisierungsschichten der Metallnanodrähte aus. Dabei sind sie leicht verarbeitbar und umweltfreundlich. Verwendet werden können sowohl synthetische als auch natürlich vorkommende Polymere. Hierbei ist es möglich, ungeladene Polymere oder geladene Polymere, nämlich kationische Polyelektrolyte oder anionische Polyelektrolyte, zu verwenden.

Geeignete ungeladene Polymere sind zum Beispiel: Polyvinylalkohol, Copolymere von Vinylalkohol, Polyvinylpyrrolidon, Polyacrylamide und Polyisocyanate.

Unter anderem sind folgende kationische Polyelektrolyte geeignet: Chitosan, modifizierte Dextrane, z.B. Diethylaminoethylmodifizierte Dextrane, Hydroxymethylcellulosetrimethylamin, Lysozym, Polylysin, Protaminsulfat, Hydroxyethylcellulosetrimethylamin und Proteine bei einem entsprechenden pH-Wert. Beispiele für synthetische Polykationen sind Polyallylamin, Polyallylaminhydrochlorid, Polyamine, Polyvinylbenzyltrimethylammoniumchlorid, Polybren, Polydiallyldimethylammoniumchlorid, Polyethylenimin, Polyimidazolin, Polyvinylamin, Polyvinylpyridin, Poly(acrylamid/methacryloxypropyltrimethylammoniumbromid), Poly(diallyldimethylammoniumchlorid/N-isopropylacrylamid), Poly(dimethylaminoethylacrylaUacrylamid), Polydimethylaminoethylmethacrylat, Polydimethylamino-epichlorhydrin, Polyethyleniminoepichlorhydrin, Polymethacryloxyethyltrimethylammoniumbromid, Hydroxypropylmethacryloxyethyldimethylammoniumchlorid, Poly(methyldiethylaminoethylmethacrylat/ acrylamid), Poly(methyl/guanidin), Polymethylvinylpyridiniumbromid, Poly(vinylpyrrolidon-dimethylaminoethylmethacrylat) und Polyvinylmethylpyridiniumbromid.

Beispiele für geeignete natürlich vorkommende Polyanionen sind Alginat, Carboxymethylamylose, Carboxymethylcellulose, Carboxy-5 methyldextran, Carageenan, Cellulosesulfat, Chondroitinsulfat, Chitosansulfat, Dextransulfat, Gummi Arabicum, Gummi Guar, Gummi Gellan, Heparin, Hyaluronsäure, Pektin, Xanthan und Proteine bei einem entsprechenden pH-Wert. Beispiele für synthetische Polyanionen sind Polyacrylate (Salze der Polyacrylsäure), Anionen von Polyaminosäuren und deren Copolymeren, Polymaleinat, Polymethacrylat; Polystyrolsulfat, Polystyrolsulfonat, Polyvinylphosphat, Polyvinylphosphonat, Polyvinylsulfat, Polyacrylamidmethylpropansulfonat, Polylactat, Poly(butadien/maleinat), Poly(ethylen/maleinat), Poly(ethacrylat/acrylat) und Poly(glycerinmethacrylat).

Nach einer vorteilhaften Weiterbildung der Erfindung umfasst das organische Material 10 ein Tensid, insbesondere ein nichtionisches Tensid, ein anionisches Tensid, ein kationisches Tensid und/oder ein amphoteres Tensid. Tenside bilden ebenfalls starke elektrische Wechselwirkungen mit den Metallnanodrähten und/oder mit den Stabilisierungsschichten der Metallnanodrähte aus. Dabei sind sie ebenfalls leicht verarbeitbar und umweltfreundlich. Verwendet werden können sowohl synthetische als auch natürlich vorkommende Tenside.

Geeignete nichtionische Tenside sind beispielsweise: Fettalkoholethoxlate, Fettalkoholethoxylate, Alkylpolyglucoside (unter anderen: Polyethylenglykol, Polyethylenglykolmethylether).

Geeignete anionische Tenside sind beispielsweise: Alkylbenzolsulfonate (CnH2n+1-C6H4-SO3-Na+), Fettalkoholsulfate (H3C-(CH2)n-CH2-O-SO3-Na+ [n = 8-16]), Alkylcarboxylate (R-COO-Na+, mit R = gesättigter oder ungesättigter, linearer Alkylrest), Seifen (unter anderen: Natriumdodecylbenzolsulfonat, Natriumlaurylsulfat, Natriumoctanoat).

Kationische geeignete Tenside sind unter anderem: Cetylpyridiniumchlorid, Cetyltrimethylammoniumbromid, Tetrabutylammoniumbromid, Tetrakis(decyl)ammoniumbromide.

Amphotere geeignete Tenside sind beispielsweise: Betaine, Sultaine, Taurin.

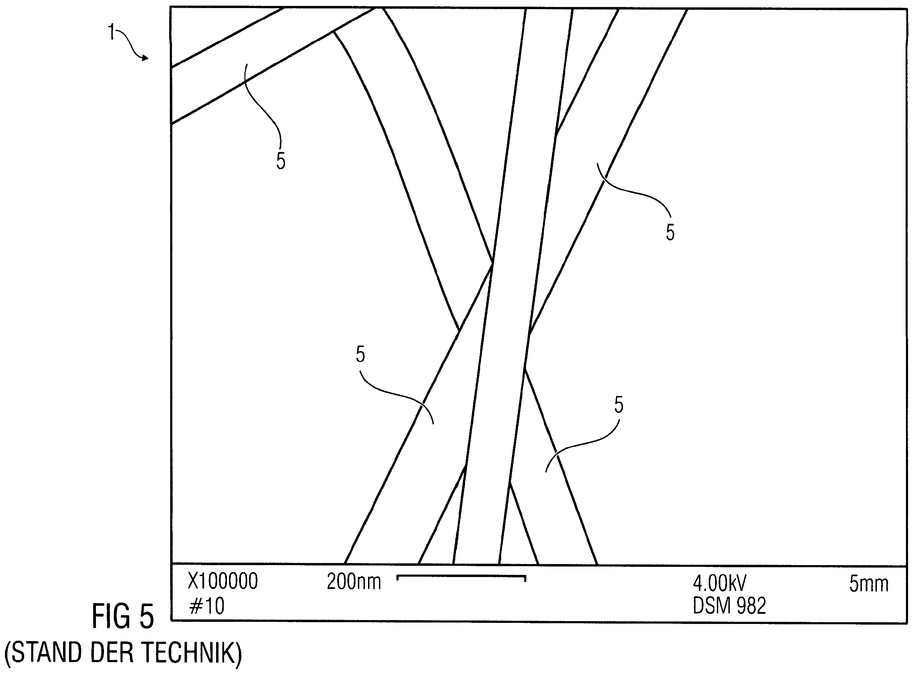

Figur 5 zeigt eine rasterelektronenmikroskopische Aufnahme einer transparenten Elektrode 1, welche gemäß dem Stand der Technik ohne funktionale organische Schicht ausgebildet ist. Hierbei sind im Wesentlichen die Metallnanodrähte 5 zu sehen, da diese einen wesentlich höheren Kontrast bewirken als organische Bestandteile der Elektrode 1. Es ist deutlich zu erkennen, dass die Metallnanodrähte 5 wie Mikadostäbchen lose übereinanderliegen und sich allenfalls punktförmig berühren, so dass die Metallnanodrähte 5 untereinander einen schlechten elektrischen Kontakt aufweisen. So entspricht die Höhe zweier sich kreuzenden Metallnanodrähte 5 dem doppelten Durchmesser der Metallnanodrähte 5.

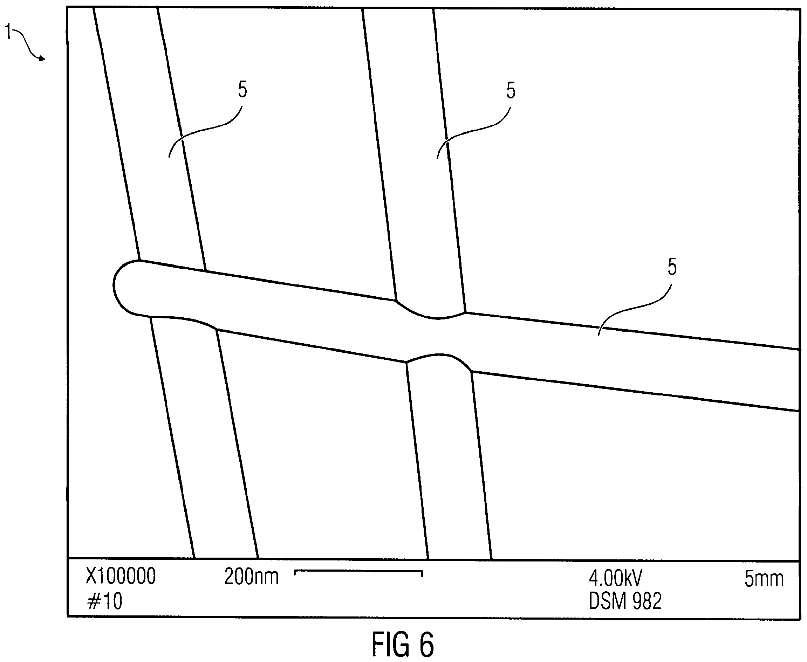

Figur 6 zeigt eine rasterelektronenmikroskopische Aufnahme einer transparenten Erfindungsgemäßen Elektrode 1, welche zwischen der Trägerschicht 2 und der elektrisch leitenden Schicht 3 eine funktionale organische Schicht 4 aufweist. Auch hier sind aus den oben genannten Gründen im Wesentlichen die Metallnanodrähte 5 zu sehen. An den Kreuzungspunkten der Metallnanodrähte 5 sind diese stoffschlüssig verbunden. Dabei geht an den Kreuzungspunkten das Material des einen Metallnanodrahtes 5 ohne klar erkennbare Grenze in das Material des anderen Metallnanodrahtes 5 über. Aus diesem Grund liegt die Höhe zweier sich kreuzender Metallnanodrähte 5 deutlich unter dem doppelten Durchmesser der Metalinanodrähte 5.

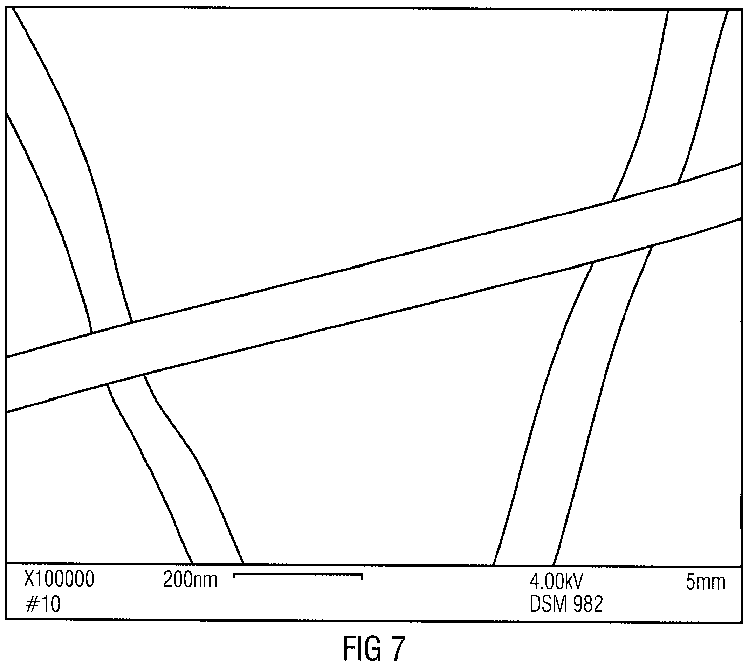

Figur 7 zeigt eine rasterelektronenmikroskopische Aufnahme einer transparenten erfindungsgemäßen Elektrode, bei welcher die elektrisch leitende Schicht zwischen der Trägerschicht und der funktionalen organische Schicht angeordnet ist. Auch hier sind an den Kreuzungspunkten der Metallnanodrähte 5 diese stoffschlüssig verbunden. Dabei geht an den Kreuzungspunkten das Material des einen Metallnanodrahtes 5 ohne klar erkennbare Grenze in das Material des anderen Metallnanodrahtes 5 über. Aus diesem Grund liegt auch hier die Höhe zweier sich kreuzender Metallnanodrähte 5 deutlich unter dem doppelten Durchmesser der Metallnanodrähte 5

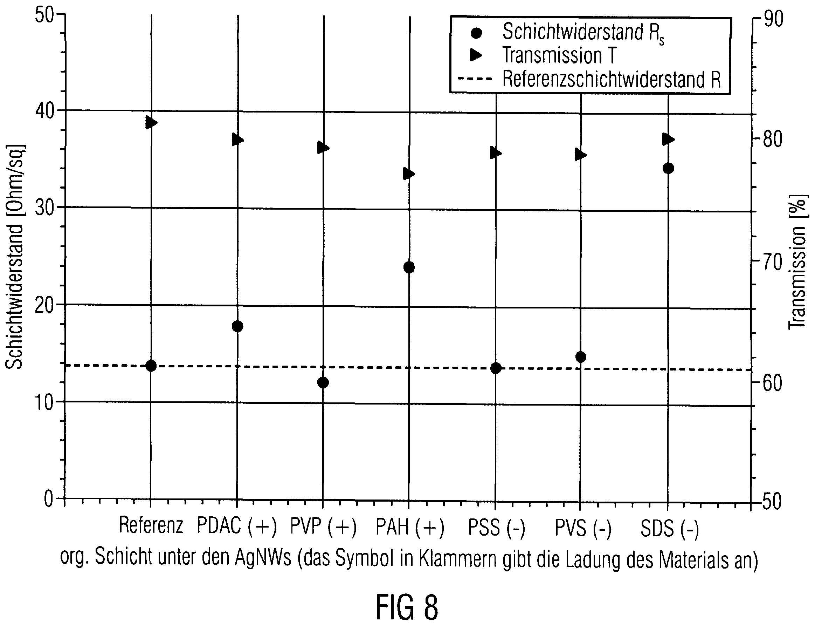

Figur 8 zeigt ein Diagramm, welches den Schichtwiderstand und den Transmissionsgrad einer Elektrode, gemessen bei 550nm Wellenlänge in Abhängigkeit von dem Material der funktionalen organischen Schicht darstellt. Hierbei sind der Schichtwiderstand R_{S} und der Transmissionskoeffizient T für die Materialien PDAC, PVP, PAH, PSS, PVS und SDS gezeigt. Die Referenzmessung bezieht sich dabei auf eine Elektrode ohne funktionale organische Schicht, welche bei 210°C 90 Minuten auf einer Heizplatte erwärmt wurde. Es ist klar erkennbar, dass die getesteten Materialien PDAC, PVP, PAH, PSS, PVS und SDS zu ähnlich gut an Schichtwiderständen Rₛ und Transmissionsgraden T führen, obwohl die höchste Prozesstemperatur mit 120 °C deutlich niedriger liegt.

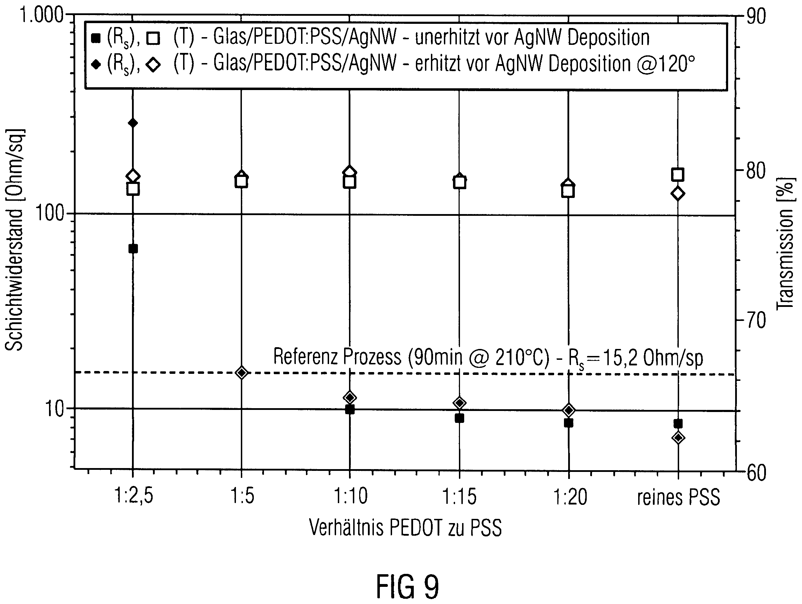

Figur 9 zeigt ein Diagramm, welches den Schichtwiderstand R_{S} und den Transmissionsgrad T einer Elektrode 1 in Abhängigkeit von dem Anteil nicht leitenden Komponenten (PSS) an dem Material (PEDOT:PSS) der funktionalen organischen Schicht darstellt. PEDOT:PSS ist dabei ein zweiphasiges Material aus den Komponenten PEDOT und PSS, wobei PEDOT ein guter Leiter PSS ein Nichtleiter ist. Dabei ist klar erkennbar, dass der Schichtwiderstand deutlich mit dem PSS-Anteil sinkt, während der Transmissionsgrad im Wesentlichen unverändert bleibt.

Nach einer vorteilhaften Weiterbildung der Erfindung besteht die organische Schicht 4 überwiegend aus elektrisch nicht leitenden Komponenten. Es hat sich gezeigt, dass bei einer organischen Schicht 4 aus überwiegend nicht leitenden Komponenten (PSS) der Schichtwiderstand R_{S} der der transparenten Elektrode 1 geringer ist, als in Fällen, in denen die organische Schicht 4 aus überwiegend leitenden Komponenten (PEDOT) besteht. Dies könnte darauf zurückzuführen sein, dass bei elektrisch nicht leitenden Komponenten (PSS) besonders starke elektrische Wechselwirkungen zwischen der funktionalen organischen Schicht 4 und den Metallnanodrähten 5 und/oder deren Stabilisierungsschichten auftreten, da bei elektrisch nicht leitenden Komponenten (PSS) ein elektrischer Ladungsausgleich nur beschränkt möglich ist. Die organische Schicht 4 besteht dann aus überwiegend elektrisch nicht leitenden Komponenten PSS, wenn der massenbezogene Anteil der elektrisch nicht leitenden Komponenten an der gesamten organischen Schicht 4 wenigstens 50 % beträgt.

Nach einer vorteilhaften Weiterbildung der Erfindung beträgt der massenbezogene Anteil der nicht leitenden Komponenten (PSS) an der organischen Schicht 4 wenigstens 80%, bevorzugt wenigstens 90%, besonders bevorzugt wenigstens 95%. Bei den angegebenen Mindestwerten für den massenbezogenen Anteil der nicht leitenden Komponenten (PSS) an der organischen Schicht 4 kann ein besonders geringer Schichtwiderstand R_{S} der transparenten Elektrode 1 bei einer geringen thermischen Nachbehandlung erreicht werden.

Gemäß einer vorteilhaften Weiterbildung der Erfindung beträgt die elektrische Leitfähigkeit der organischen Schicht 4 höchstens 0,5 S/cm, bevorzugt höchstens 0,1 S/cm, besonders bevorzugt höchstens 0,05 S/cm. Bei den angegebenen Höchstwert für die elektrische Leitfähigkeit der organischen Schicht 4 ergeben sich hinreichend starke elektrische Wechselwirkungen zwischen der funktionalen organischen Schicht 4 und den Metallnanodrähten 5 und/oder den Stabilisierungsschichten der Metallnanodrähte 5 um die Stabilisierungsschichten soweit zu schwächen, dass die Metallnanodrähte 5 eine stoffschlüssige Verbindung eingehen können.

Die Silbernanodraht-Elektroden 1 werden in einem Ausführungsbeispiel mit einer funktionalisierenden organischen Schicht 4 behandelt. Diese organische Schicht 4 kann ein Tensid, ein Polyelektrolyt oder ein wasserlösliches Polymer sein. Als Tensid kommen kationische (z.B. Hexadecyltrimethylammonium Bromid (HDAB)), nicht-ionische (z.B. Polyethylenglykol (PGE)) oder anionische (z.B. Natriumdodecylsulfat (SDS)) Tenside in Frage. Die Polyelektrolyten sind entweder kationischer (z.B. Polydiallyldimethylammonium Chlorid (PDAC), Polyethylenimin (PEI), Polyallylamin Hydrochlorid (PAH)) oder anionischer (z.B. Polystyrolsulfanot (PSS), Polyvinylsulfonat (PVS)) Natur. Als wasserlösliches Polymer können z.B. Polyvinylalkohol (PVA) oder Polyvinylpyridin (PVP) verwendet werden.

Eine Möglichkeit stellt hierbei die Vorbehandlung des Substrates (Glas- oder PET-Substrat) mit einer organischen Schicht dar 4. Nach einer Vorreinigung des Substrates werden diese mit einem in Wasser 9 gelösten organischen Material 10 beschichtet. Die Beschichtung geschieht wahlweise mit dem Rotations-, Sprüh- oder Tauchbeschichtungsverfahren unter Atmosphärenbedingung (Figur 4). Diese Schichten werden für 15 Minuten auf einer Heizplatte bei 120°C gelagert, um zurückgebliebenes Wasser neun zu entfernen und die einige Nanometer dünnen Schichten 4 zu fixieren. Anschließend werden in z.B. in Ethanol 8 oder Isopropanol 8 gelöste Silbernanodrähte 5 mit einem Sprühbeschichtungsprozess auf das vorbehandelte Substrat 2 aufgebracht. Das Substrat 2 wird hierbei auf 80°C erwärmt, um eine homogene Abscheidung der Drähte 5 zu gewährleisten. Ohne weitere Prozessierungsschritte besitzt die resultierende AgNW-Elektrode 1 einen geringen Schichtwiderstand R_{S} bei gleichzeitig hoher Transmission T (Figur 8).

Alternativ kann die Probe auch nach dem Auftrag der Silbernanodrähte 5 mit dem organischen Material 4 beschichtet werden. Das Vorgehen ist analog zu ebengenannter Möglichkeit, jedoch mit einer nachträglichen Rotationsbeschichtung der organischen Schicht 4 auf die AgNW-Elektrode 1. Auch hier werden die Proben für 15 Minuten auf eine 120°C Heizplatte gelegt, um Restwasser oder Lösungsmittel aus der Schicht zu entfernen.

Ein Grund für den großen Schichtwiderstand R_{S} der Silbernanodrähte 5 ist der schlechte elektrische Kontakt der Drähte 5 untereinander (Figur 5). Die hier vorgestellte erste Methode behebt dieses Problem durch eine Funktionalisierung der Substratoberfläche 2 mit einer geeigneten organischen Schicht 4. Hierbei wird unter anderem die Adhäsion der Nanodrähte auf der Oberfläche 2 stark erhöht. Grund hierfür sind Liganden aus PVP um den Silbernanodraht 5, welche für die Synthese der Drähte 5 benötigt werden und nicht vollständig entfernt werden können. Diese wechselwirken stark mit der Organikschicht 4 auf der Substratoberfläche 2. Dadurch werden die Kontakte der Drähte 5 untereinander verbessert, was zu einer deutlichen Verringerung des Schichtwiderstands Rₛ der Elektrode 1 führt (Figur 6). Die Ladungsart der org. Schicht ist hierbei unentscheidend.

Ein völlig anderer Mechanismus kommt zusätzlich zum Tragen, wenn das organische Material 4 auf die Silbernanodrahtelektrode 5 aufgebracht wird. Durch den Prozess des Lösungsmittelverdampfens geschieht eine Kompression der Schicht 3. Dieser Prozess beeinflusst auch die Silbernanodrähte 5, welche näher aneinander gebracht werden (Figur 7). Dadurch wird - wie bei obengenannter Methode - der Kontakt der Drähte 5 untereinander erhöht, was ein Absinken des Schichtwiderstands zur Folge hat.

Die vorgestellten Methoden vereinfachen die Herstellung von transparenten, hochleitfähigen und flexiblen Silbernanodrahtelektroden 1 erheblich. Durch die Flexibilität der Silbernanodrähte 5 ist ein Rolle-zu-Rolle-Verfahren zur großflächigen Herstellung transparenter Elektroden 1 auf Foliensubstraten 2 wie z.B. PET, PEN, PC oder anderen Polymer- oder Metallsubstraten möglich. Die Reduzierung der maximalen Prozesstemperatur und Dauer der Wärmeeinwirkung reduziert hier weiter die Kosten für die Einrichtung solcher Herstellungsstrecken.

Ein weiterer Vorteil ist die Auftrennung von funktionalisierender Zwischenschicht 4 und Nanodrahtdispersion 3 in ein zweistufiges Verfahren. Dies ermöglicht eine größere Freiheit in der Prozessierung. So kann die Nanodrahtdispersion 3 in ihrer chemischen Zusammensetzung (z.B. Lösungsmittel, Stabilisatoren) variiert und evtl mit anderen Nanopartikeln kombiniert werden, wobei gleichzeitig keine Rücksicht auf Nachbehandlungsschritte zur Erhöhung der Leitfähigkeit genommen werden muss.

Ein Vorteil der organischen Schicht 4 unter den Nanodrähten 5 ist, dass sie am Ende des Prozesses noch offen liegen. Hier ist eine Weiterverarbeitung in jeglicher denkbarer Art und Weise vorstellbar. Auch die optischen Eigenschaften (z.B. die gezielte Veränderung der Streueigenschaften dieser Schicht) lassen sich noch unabhängig optimieren.

Je nach Anwendung kann es auch von Nutzen sein, die Nanodrahtelektrode in einer transparenten Organikschicht 6 einzubetten. Dies reduziert Unebenheiten, welche durch die Silbernanodrähte entstehen und verringert somit Probleme in der Weiterverarbeitung der Elektrode 1.

Aspekte der vorliegenden Erfindung, welche im Zusammenhang mit einer erfindungsgemäßen Vorrichtung erläutert sind, gelten, außer z. B. in Fällen eindeutiger Unvereinbarkeiten, ebenso für ein erfindungsgemäßes Verfahren. Ebenso gelten Aspekte der vorliegenden Erfindung, welche im Zusammenhang mit einem erfindungsgemäßen Verfahren erläutert sind, für eine erfindungsgemäße Vorrichtung.

### Bezugszeichenliste:

- 1: transparente flexible Elektrode
- 2: Trägerschicht
- 3: elektrisch leitende Schicht
- 4: funktionale organische Schicht
- 5: Metallnanodrähte
- 6: transparente Abdeckschicht
- 7: Suspension
- 8: Flüssigkeit
- 9: Lösungsmittel
- 10: organisches Material
- R_{S}: Schichtwiderstand
- T: Transmissionskoeffizient

### Referenzliste:

[Peumans2008] Lee, J.-Y., Connor, S. T., Cui, Y., & Peumans, P. (2008). Solution-processed metal nanowire mesh transparent electrodes. Nano letters, 8(2), 689-92. DOI: 10.1021/nl073296g
[Alden2007] ALDEN, J., DAI, H., & KNAPP, M. (2007). NANOWIRES-BASED TRANSPARENT CONDUCTORS. WO Patent. Retrieved from http://patentscope.wipo.int/search/en/WO2007022226
[Kim2009] Kim, H.-K., Jeong, J.-A., Choi, K.-H., Jeong, S.-W., & Kang, J.-W. (2009). Characteristics of Flexible ITO Electrodes Grown by Continuous Facing Target Roll-to-Roll Sputtering for Flexible Organic Solar Cells. Electrochemical and Solid-State Letters, 12(5), H169. DOI: 10.1149/1.3086260
[Sachse2013] Sachse, C., Müller-Meskamp, L., Bormann, L., Kim, Y. H., Lehnert, F., Philipp, A., Beyer, B., et al. (2013). Transparent, dip-coated silver nanowire electrodes for small molecule organic solar cells. Organic Electronics, 14(1), 143-148. DOI: 10.1016/j.orgel.2012.09.032
[Hu2010] Hu, L., Kim, H. S., Lee, J.-Y., Peumans, P., & Cui, Y. (2010). Scalable coating and properties of transparent, flexible, silver nanowire electrodes. ACS nano, 4(5), 2955-63. DOI: 10.1021/nn1005232
[De2009] De, S., Higgins, T. M., Lyons, P. E., Doherty, E. M., Nirmalraj, P. N., Blau, W. J., Boland, J. J., et al. (2009). Silver Nanowire Networks as Flexible, Transparent, Conducting Films: Extremely High DC to Optical Conductivity Ratios. ACS nano, 3(7), 1767-74. DOI: 10.1021/nn900348c
[Choi2013a] Choi, D. Y., Kang, H. W., Sung, H. J., & Kim, S. S. (2013). Annealing-free, flexible silver nanowire-polymer composite electrodes via a continuous two-step spray-coating method. Nanoscale, 5(3), 977-83. DOI: 10.1039/c2nr32221h
[Pschenitzka2013] Pschenitzka, F. (2013). US 2013/105770 A1
[Bories-Azeau2012] Bories-Azeau et al.(2012). US 2012/118617 A1

## Patentansprüche

1. Transparente Elektrode umfassend:
wenigstens eine Trägerschicht (2) zur Stabilisierung der Elektrode (1);
wenigstens eine Metallnanodrähte (5) enthaltende elektrisch leitende Schicht (3), welche dadurch hergestellt ist, dass eine Suspension (7) aus einer Flüssigkeit (8) und den mit einer Stabilisierungsschicht umgebenen Metallnanodrähten (5) entlang der Trägerschicht (2) ausgebreitet und durch Entfernen der Flüssigkeit (8) getrocknet ist; und
wenigstens eine funktionale entlang der Trägerschicht (2) ausgebildete organische Schicht (4),
**dadurch gekennzeichnet, dass**
die organische Schicht (4) während des Trocknens der elektrisch leitenden Schicht (3) durch eine Wechselwirkung mit den Metallnanodrähten (5) und/oder mit den Stabilisierungsschichten der Metallnanodrähte (5) eine Wechselwirkung zwischen den Metallnanodrähten (5) und den Stabilisierungsschichten so verändert, dass zwischen den Metallnanodrähten (5) eine stoffschlüssige Verbindung entsteht.

2. Elektrode nach vorstehendem Anspruch, wobei die organische Schicht (4) überwiegend aus elektrisch nicht leitenden Komponenten besteht.

3. Elektrode nach vorstehendem Anspruch, wobei der massenbezogene Anteil der nicht leitenden Komponenten an der organischen Schicht (4) wenigstens 80%, bevorzugt wenigstens 90%, besonders bevorzugt wenigstens 95%, beträgt.

4. Elektrode nach einem der vorstehenden Ansprüche, wobei die Trägerschicht (2) eine flexible Folie ist.

5. Elektrode nach einem der vorstehenden Ansprüche, wobei die Metallnanodrähte (5) Silbernanodrähte, Kupfernanodrähte, Metallnanodrähte aus Legierungen aus verschiedenen Metallen und/oder Core-Shell-Metallnanodrähte umfassen.

6. Elektrode nach einem der vorstehenden Ansprüche, wobei die organische Schicht (4) zwischen der Trägerschicht (2) und der elektrisch leitenden Schicht (3) ausgebildet ist.

7. Elektrode nach vorstehendem Anspruch, wobei die elektrisch leitende Schicht (3) auf einer der organischen Schicht (4) abgewandten Seite mit einer transparenten Abdeckschicht (6) versehen ist.

8. Elektrode nach einem der Ansprüche 1 bis 6, wobei die organische Schicht (4) auf der der Trägerschicht (2) abgewandten Seite der elektrisch leitenden Schicht (3) ausgebildet ist.

9. Elektrode nach einem der vorstehenden Ansprüche, wobei das organische Material (10) ein wasserlösliches Polymer und/oder ein alkohollösliches Polymer, insbesondere ein ungeladenes Polymer, ein anionisches Polymer und/oder ein kationisches Polymer, umfasst.

10. Elektrode nach einem der vorstehenden Ansprüche, wobei das organische Material (10) ein Tensid, insbesondere ein nichtionisches Tensid, ein anionisches Tensid, ein kationisches Tensid und/oder ein amphoteres Tensid umfasst.

11. Verfahren zur Herstellung einer transparente Elektrode (1), umfassend die Schritte:
Bereitstellen wenigstens einer Trägerschicht (2) zur Stabilisierung der Elektrode (1);
Herstellen wenigstens einer Metallnanodrähte (5) enthaltenden elektrisch leitenden Schicht (3), indem eine Suspension (7) aus einer Flüssigkeit (8) und den mit einer Stabilisierungsschicht umgebenen Metallnanodrähten (5) entlang der Trägerschicht (2) ausgebreitet und durch Entfernen der Flüssigkeit (8) getrocknet wird; und
Ausbilden wenigstens einer funktionalen organischen Schicht (4) entlang der Trägerschicht (2),
**dadurch gekennzeichnet, dass**
die organische Schicht (4) während des Trocknens der elektrisch leitenden Schicht (3) durch eine Wechselwirkung mit den Metallnanodrähten (5) und/oder mit den Stabilisierungsschichten der Metallnanodrähte (5) eine Wechselwirkung zwischen den Metallnanodrähten (5) und den Stabilisierungsschichten so verändert, dass zwischen den Metallnanodrähten (5) eine stoffschlüssige Verbindung entsteht.

12. Verfahren nach vorstehendem Anspruch, wobei die organische Schicht (4) bezüglich eines Materials der Stabilisierungsschicht als Lösungsmittel wirkt.

13. Verfahren nach einem der Ansprüche 11 oder 12, wobei die organische Schicht (4) zwischen der Trägerschicht (2) und der elektrisch leitenden Schicht (3) ausgebildet wird.

14. Verfahren nach vorstehendem Anspruch, wobei die elektrisch leitende Schicht (3) auf einer der organischen Schicht (4) abgewandten Seite mit einer transparenten Abdeckschicht (6) versehen wird.

15. Verfahren nach einem der Ansprüche 11 bis 14, wobei die organische Schicht (4) auf der der Trägerschicht (2) abgewandten Seite der elektrisch leitenden Schicht (3) ausgebildet wird.

16. Verfahren nach einem der Ansprüche 11 bis 15, wobei die organische Schicht (4) mittels eines Rotations-, Sprüh-, Druck- und/oder Tauchbeschichtungsverfahrens hergestellt wird, indem ein in einem Lösungsmittel (9) gelöstes organisches Material (10) ausgebreitet und durch Entfernen des Lösungsmittels (9) verfestigt wird.

17. Verfahren nach vorstehendem Anspruch, wobei das Entfernen des Lösungsmittels (9) einen Heizschritt mit einer Maximaltemperatur umfasst, welche höchstens 150°C, bevorzugt höchstens 120°C, besonders bevorzugt höchstens 100°C, beträgt.

18. Verfahren nach einem der Ansprüche 11 bis 17, wobei die Suspension (7) mittels eines Rotations-, Sprüh-, Druck- und/oder Tauchbeschichtungsverfahrens ausgebreitet wird.

19. Verfahren nach einem der Ansprüche 11 bis 18, wobei die Suspension (7) während des Ausbreitens beheizt ist, wobei eine maximale Temperatur der Suspension (7) höchstes 100°C, bevorzugt höchstens 80°C, besonders bevorzugt höchstens 70°C, beträgt.

## Claims

1. A transparent electrode comprising:
at least one carrier layer (2) for stabilizing the electrode (1);
at least one electrically conductive layer (3) containing metal nanowires (5), which is produced by spreading a suspension (7) of a liquid (8) and the metal nanowires (5) surrounded by a stabilizing layer, along the carrier layer (2) and drying same by removing the liquid (8); and
at least one functional organic layer (4) formed along the carrier layer (2),
**characterized in that**
the organic layer (4), while the electrically conductive layer (3) dries, by an interaction with the metal nanowires (5) and/or with the stabilizing layers of the metal nanowires (5), changes an interaction between the metal nanowires (5) and the stabilizing layers such that the result is a substance-to-substance bond between the metal nanowires (5).

2. The electrode in accordance with the preceding claim, wherein the organic layer (4) predominantly consists of electrically non-conducting components.

3. The electrode in accordance with the preceding claim, wherein the mass-related portion of the non-conducting components in the organic layer (4) is at least 80%, preferably at least 90%, and particularly preferably at least 95%.

4. The electrode in accordance with any of the preceding claims, wherein the carrier layer (2) is a flexible film.

5. The electrode in accordance with any of the preceding claims, wherein the metal nanowires (5) comprise silver nanowires, copper nanowires, metal nanowires of alloys of different metals and/or core-shell metal nanowires.

6. The electrode in accordance with any of the preceding claims, wherein the organic layer (4) is formed between the carrier layer (2) and the electrically conductive layer (3).

7. The electrode in accordance with the preceding claim, wherein the electrically conductive layer (3) is provided with a transparent cover layer (6) on a side facing away from the organic layer (4).

8. The electrode in accordance with any of claims 1 to 6, wherein the organic layer (4) is formed on that side of the electrically conductive layer (3) facing away from the carrier layer (2).

9. The electrode in accordance with any of the preceding claims, wherein the organic material (10) comprises a water-soluble polymer and/or an alcohol-soluble polymer, in particular an uncharged polymer, anionic polymer and/or cationic polymer.

10. The electrode in accordance with any of the preceding claims, wherein the organic material (10) comprises a tenside, in particular a non-ionic tenside, anionic tenside, cationic tenside and/or amphoteric tenside.

11. A method for producing a transparent electrode (1), comprising the steps of:
providing at least one carrier layer (2) for stabilizing the electrode (1);
producing at least one electrically conductive layer (3) containing metal nanowires (5) by spreading a suspension (7) of a liquid (8) and the metal nanowires (5) surrounded by a stabilizing layer, along the carrier layer (2) and drying same by removing the liquid (8); and
forming at least one functional organic layer (4) along the carrier layer (2),
**characterized in that**
the organic layer (4), while the electrically conductive layer (3) dries, by an interaction with the metal nanowires (5) and/or with the stabilizing layers of the metal nanowires (5), changes an interaction between the metal nanowires (5) and the stabilizing layers such that the result is a substance-to-substance bond between the metal nanowires (5).

12. The method in accordance with the preceding claim, wherein the organic layer (4) has the effect of a solvent relative to a material of the stabilizing layer.

13. The method in accordance with any of claims 11 or 12, wherein the organic layer (4) is formed between the carrier layer (2) and the electrically conductive layer (3).

14. The method in accordance with the preceding claim, wherein the electrically conductive layer (3) is provided with a transparent cover layer (6) on a side facing away from the organic layer (4).

15. The method in accordance with any of claims 11 to 14, wherein the organic layer (4) is formed on that side of the electrically conductive layer (3) facing away from the carrier layer (2).

16. The method in accordance with any of claims 11 to 15, wherein the organic layer (4) is produced by means of a rotation, spray, printing and/or dip coating method by spreading an organic material (10) dissolved in a solvent (9) and solidifying same by removing the solvent (9).

17. The method in accordance with the preceding claim, wherein removing the solvent (9) comprises a heating step at a maximum temperature which is at most 150°C, preferably at most 120°C, and particularly preferably at most 100°C.

18. The method in accordance with any of claims 11 to 17, wherein the suspension (7) is spread by means of a rotation, spray, printing and/or dip coating method.

19. The method in accordance with any of claims 11 to 18, wherein the suspension (7) is heated while spreading, wherein a maximum temperature of the suspension (7) is at most 100°C, preferably at most 80°C, and particularly preferably at most 70°C.

## Revendications

1. Electrode transparente, comprenant:
au moins une couche de support (2) destinée à stabiliser l'électrode (1);
au moins une couche électriquement conductrice (3) contenant des nanofils métalliques (5), qui est préparée en étalant une suspension (7) composée d'un liquide (8) et des nanofils métalliques (5) entourés d'une couche de stabilisation le long de la couche de support (2) et en la séchant par élimination du liquide (8); et
au moins une couche organique fonctionnelle (4) formée le long de la couche de support (2),
**caractérisée par le fait que**
la couche organique (4) change, pendant le séchage de la couche électriquement conductrice (3), par une interaction avec les nanofils métalliques (5) et/ou avec les couches de stabilisation des nanofils métalliques (5), par une interaction entre les nanofils métalliques (5) et les couches de stabilisation, de sorte qu'il se produise une connexion en liaison de matière entre les nanofils métalliques (5).

2. Electrode selon la revendication précédente, dans laquelle la couche organique (4) est constituée majoritairement de composants électriquement non conducteurs.

3. Electrode selon la revendication précédente, dans laquelle la part, sur base de la masse, des composants non conducteurs dans la couche organique (4) est d'au moins 80%, de préférence d'au moins 90%, plus préférablement d'au moins 95%.

4. Electrode selon l'une des revendications précédentes, dans laquelle la couche de support (2) est un film souple.

5. Electrode selon l'une des revendications précédentes, dans laquelle les nanofils métalliques (5) comportent des nanofils en argent, des nanofils en cuivre, des nanofils métalliques en alliages métalliques différents et/ou des nanofils métalliques à structure noyau-coquille.

6. Electrode selon l'une des revendications précédentes, dans laquelle la couche organique (4) est formée entre la couche de support (2) et la couche électriquement conductrice (3).

7. Electrode selon la revendication précédente, dans laquelle la couche électriquement conductrice (3) est pourvue, d'un côté opposé à la couche organique (4), d'une couche de recouvrement transparente (6).

8. Electrode selon l'une des revendications 1 à 6, dans laquelle la couche organique (4) est formée du côté de la couche électriquement conductrice (3) opposé à la couche de support (2).

9. Electrode selon l'une des revendications précédentes, dans laquelle le matériau organique (10) comporte un polymère soluble dans de l'eau et/ou un polymère soluble dans de l'alcool, en particulier un polymère non chargé, un polymère anionique et/ou un polymère cationique.

10. Electrode selon l'une des revendications précédentes, dans laquelle le matériau organique (10) comporte un agent tensioactif, en particulier un agent tensioactif non ionique, un agent tensioactif anionique, un agent tensioactif cationique et/ou un agent tensioactif amphotère.

11. Procédé de fabrication d'une électrode transparente (1), comportant les étapes consistant à:
prévoir au moins une couche de support (2) destinée à stabiliser l'électrode (1);
préparer au moins une couche électriquement conductrice (3) contenant des nanofils métalliques (5) en étalant une suspension (7) composée d'un liquide (8) et des nanofils métalliques (5) entourés d'une couche de stabilisation le long de la couche de support (2) et en la séchant par élimination du liquide (8); et
former au moins une couche organique fonctionnelle (4) le long de la couche de support (2),
**caractérisé par le fait que**
la couche organique (4) change, pendant le séchage de la couche électriquement conductrice (3), par une interaction avec les nanofils métalliques (5) et/ou avec les couches de stabilisation des nanofils métalliques (5), par une interaction entre les nanofils métalliques (5) et les couches de stabilisation, de sorte qu'il se produise une connexion en liaison de matière entre les nanofils métalliques (5).

12. Procédé selon la revendication précédente, dans lequel la couche organique (4) agit comme solvant en ce qui concerne un matériau de la couche de stabilisation.

13. Procédé selon l'une des revendications 11 ou 12, dans lequel la couche organique (4) est formée entre la couche de support (2) et la couche électriquement conductrice (3).

14. Procédé selon la revendication précédente, dans lequel la couche électriquement conductrice (3) est pourvue, d'un côté opposé à la couche organique (4) d'une couche de recouvrement transparente (6).

15. Procédé selon l'une des revendications 11 à 14, dans lequel la couche organique (4) est formée d'un côté de la couche électriquement conductrice (3) opposé à la couche de support (2).

16. Procédé selon l'une des revendications 11 à 15, dans lequel la couche organique (4) est produite au moyen d'un procédé de rotation, de pulvérisation, d'impression et/ou de revêtement par immersion en étalant le matériau organique (10) dissous dans un solvant (9) et en la solidifiant par élimination du solvant (9).

17. Procédé selon la revendication précédente, dans lequel l'élimination du solvant (9) comporte une étape de chauffage à une température maximale qui est de tout au plus 150°C, de préférence de tout au plus 120°C, de manière particulièrement préférée de tout au plus 100°C.

18. Procédé selon l'une des revendications 11 à 17, dans lequel la suspension (7) est étalée au moyen d'un procédé de rotation, d'impression, de pulvérisation et/ou de revêtement par immersion.

19. Procédé selon l'une des revendications 11 à 18, dans lequel la suspension (7) est chauffée pendant l'étalement, une température maximale de la suspension (7) étant de tout au plus 100°C, de préférence de tout au plus 80°C, de manière particulièrement préférée de tout au plus 70°C.
